# EUROPÄISCHE PATENTSCHRIFT

(11) **EP 0 609 488 B1**
(45) Veröffentlichungstag und Bekanntmachung des Hinweises auf die Patenterteilung: **05.07.1995**
(21) Anmeldenummer: 93114233.5
(22) Anmeldetag: 06.09.1993
(51) Int. Cl.: C23C 14/50, C23C 14/34

(54) **Vorrichtung zum Ein- und/oder Ausschleusen einer Maske in die beziehungsweise aus der Kammer einer Vakuum-Beschichtungsanlage**
Apparatus to transport a mask in or out of the chamber of a vacuum coating plant
Appareil pour faire entrer et/ou sortir un masque respectivement dans ou hors de la chambre d'un dispositif de revêtement sous vide

(30) Priorität: 02.02.1993 DE 4302794
(43) Veröffentlichungstag der Anmeldung: 10.08.1994
(73) Patentinhaber: LEYBOLD AKTIENGESELLSCHAFT, D-63450 Hanau (DE)
(72) Erfinder: Zejda, Jaroslav, D-63517 Rodenbach (DE)

(56) Entgegenhaltungen:
- EP-A- 0 389 820
- DE-A- 3 912 295
- DE-A- 4 037 580
- DE-A- 4 110 490

## Beschreibung

Die Erfindung betrifft eine Vorrichtung zum Ein- und /oder Ausschleusen einer Maske für ein vorzugsweise kreisringscheibenförmiges flaches Substrat in die bzw. aus der Kammer einer Vakuum-Beschichtungsanlage mit einem in einer ersten Ausschleuskammer verschiebbar gelagerten bis in die Ebene des Substrats bewegbaren Stößel zur Halterung und zum Transport der mit einer Aufnahmebohrung versehenen Maske.

Bekannt ist es flache, scheibenförmige Substrate z.B. CD-ROM's oder magnetooptische Disc's vor dem Beschichten in Vakuum-Beschichtungsanlagen mit Schablonen teilweise abzudecken bzw. mit Masken zu versehen, damit die Randzonen oder zentralen Partien der Substrate von einer Beschichtung ausgespart bleiben. Derartige Abdeck-Schablonen oder Masken werden üblicherweise vor dem Beschichtungsvorgang, d. h. außerhalb des Vakuumbereiches an den Substraten angebracht, so daß die Substrate zusammen mit den an ihnen befestigten Masken in die Prozeßkammer der Beschichtungsanlage eingeschleust bzw. - nach dem Beschichtungsvorgang - wieder aus dieser ausgeschleust werden. Diese Art der Maskierung hat den Nachteil, daß die Masken schnell "verbraucht" sind, da sich an ihren Außenflächen Flitter bildet, der den Beschichtungsprozeß erheblich stören kann.

Der vorliegenden Erfindung liegt deshalb die Aufgabe zugrunde, eine Vorrichtung zu schaffen, die dem Aufsetzen und Entfernen der Masken auf die Substrate innerhalb des Vakuumbereichs der Beschichtungsanlage gestattet und es insbesondere ermöglicht, die Masken nach einer Reihe von Beschichtungszyklen aus der Anlage heraus- bzw. in diese hineinzuschleusen.

Diese Aufgabe wird erfindungsgemäß dadurch gelöst, daß ein Stößel quer zur Ebene des Substrats gehalten und geführt ist und mit einem quer zur Längsrichtung des Stößels bewegbaren Schieber zusammenwirkt, dessen Kopfteil gabelförmig ausgeformt ist und auf den krempenförmigen Rand der Maske aufschiebbar ist und diesen umklammert, wozu der Schieber von seiner Ausgangsposition in einer zweiten Ausschleus-Kammer in einer Vorschubbewegung bis an den Transportpfad des Stößels heranführbar und dort auf den krempenförmigen Rand aufpreßbar ist und anschließend vom Schieber in einer Rückhubbewegung in die zweite Ausschleus-Kammer transportierbar ist aus der die Maske anschließend und nach dem Schließen einer die beiden Kammer voneinander abtrennender Klappe mittels eines weiteren Stößels heraustransportierbar ist.

Weitere Einzelheiten und bevorzugte Merkmale der Erfindung sind in den abhängigen Patentansprüchen 2 bis 5 näher beschrieben und gekennzeichnet.

Die Erfindung läßt die verschiedensten Ausführungsmöglichkeiten zu; eine davon ist in der anhängenden Zeichnung schematisch näher dargestellt.

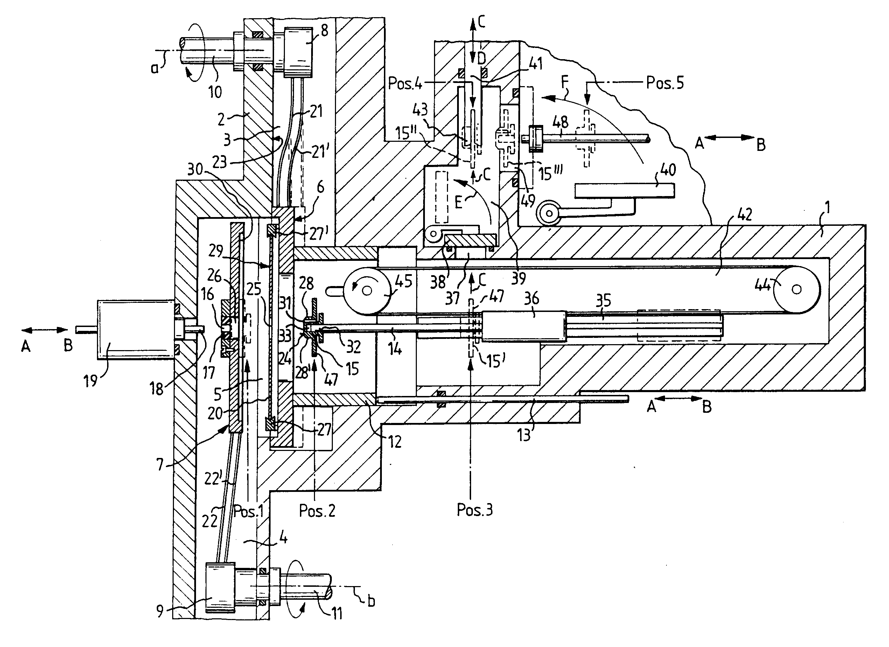

Die Vorrichtung besteht im Wesentlichen aus einem druckdichten Gehäuse 1,2, das zwei in zueinander parallelen Ebenen angeordnete Kammern 3,4 aufweist, die über eine Öffnung 5 miteinander verbunden sind, wobei jede der beiden Kammern 3,4 als kreiszylidrischer Hohlraum ausgebildet ist und wobei die Längsachsen der beiden kreiszylindrischen Kammern 3,4 parallel zueinander, jedoch gegeneinander versetzt angeordnet sind. Sowohl in der Kammer 3, als auch in der benachbarten Kammer 4 sind Transportkellen 6,7 angeordnet, die jeweils nach Art von Radspeichen fest mit Haben 8,9 verbunden sind, die auf Antriebswellen 10,11 sitzen, die von nicht näher dargestellten Motoren antreibbar sind. Während in der Kammer 4 Transportkellen 7 rotieren, die Substrate 20 auf einer Kreisbahn von einer Behandlungsstation zur nächsten Behandlungsstation bewegen, bewegen die Transportkellen 6 die Substrate von einer Ein-/Ausschleusstation (nicht dargestellt) zur dargestellten Übergabestation und umgekehrt (von der Übergabestation zur Ein-/Ausgabestation). Im Bereich der Öffnung 5, die die beiden Kammern 3,4 miteinander verbindet, ist eine Druckhülse 12 vorgesehen, die im Gehäuse 1 gehalten und geführt ist und eine Bewegung der Druckhülse 12 in Pfeilrichtung A-B durch Verschieben des Stößels 13 gestattet. Es ist weiterhin ein Stößel 14 auf einem auf einer Schiene 35 gelagerten Gleitschuh 36 vorgesehen, der ebenfalls in Pfeilrichtung A-B motorisch bewegbar ist und der mit einer Maske 15 korrespondiert, wobei die Längsachse des Stößels 14 mit der zentralen Aufnahmebohrung 16 eines Ringmagneten 17 fluchtet, wenn sich die Transportkelle 7 in der in der Zeichnung dargestellten Position befindet. Mit dem Stößel 14 fluchtet außerdem ein zweiter Stößel 18, der in einer Motor-Einheit 19 gelagert ist, die auf dem Gehäuse 2 dem Gleitschuh 36 gegenüberliegend angeordnet ist und die ebenfalls eine Bewegung des Stößels 18 in Richtung A-B gestattet.

In der Zeichnung sind die Stellungen der Transportkellen 6,7 so dargestellt, daß die Übergabe eines Substrats 20 von der Transportkelle 6 zur Transportkelle 7 erfolgen kann (derartige Transportkellen und ihre Antriebseinheiten sind in allen Einzelheiten näher beschrieben und dargestellt in der DE 39 12 295 A1).

Zum Zwecke der Übergabe des Substrats 20 an die Tranportkelle 7 wird zunächst die Transportkelle 6 in Pfeilrichtung A von der Druckhülse 12 aus einer mittleren, strichliert angedeuteten Position, gegen die Kraft der Federarme 21, 21' an die Innenwand 23 gedrückt, wobei gleichzeitig der Antrieb der Welle 10 blockiert wird. Danach bewegt sich der Stößel 14 in Richtung A so weit nach links auf die in der dargestellten Stellung blockierten Transportkelle 6 zu, bis das Kopfteil 24 der Maske 15 in die zentrale Öffnung 25 des Substrats 20 eingetaucht ist und danach weiter unter Mitnahme des Substrats 20, bis das Kopfteil 24 am Magneten 17 anliegt (Pos. 1) und von diesem in dieser Stellung in der Bohrung 26 gehalten wird. Um die Mitnahme des Substrats 20 von der dargestellten Position (Pos. 2) in die strichliert eingezeichnete Position an der Transportkelle 7 (Pos. 1) zu ermöglichen, schwenken gleichzeitig die Halteklauen 27, 27'... radial nach außen, so daß sie das Substrat 20 freigeben (Ein hierfür geigneter Mechanismus und Antrieb ist an der Transportkelle 6 angeordnet; jedoch nicht näher beschrieben und dargestellt). Die Maske 15 ist nun in der Bohrung 26 so zentriert und am Magneten 17 gehalten, daß sich der Stößel 14 in Pfeilrichtung B in seine Ausgangsposition zurückbewegt (Pos. 2), wobei gleichzeitig die Transportkelle 7 um die Rotationsachse b weitergedreht werden kann, um das Substrat 20 zur ersten Behandlungsstation zu transportieren. Mit der Weiterbewegung bzw. Schwenkbewegung der dargestellten Transportkelle 7 wird eine weitere, dieser benachbarten Transportkelle 7' in die Position geschwenkt, in der sich die dargestellte Transportkelle vorher befand, so daß eine Übergabe des von dieser gehaltenen Substrats 20 an die gegenüberliegend veharrende Transportkelle 6' erfolgen kann. Zu diesem Zweck bewegt sich der Stößel 18 nun, angetrieben vom Motor 19, in Pfeilrichtung B bis sein vorderes Ende auf den Kopf der Maske 15 stößt, diese Maske vom Magneten 17 an der Transportkelle 7 abreißt und dann die Maske 15 zusammen mit dem Substrat 20 in Pfeilrichtung B bis in die Ebene der Halteklauen 27, 27' transportiert. Da das Kopfteil 24 jeder Maske 15 mit Haltenoppen 28, 28',... ausgestattet ist, bleibt dabei die Maske 15 solange am Substrat 20 haften bzw. mit dieser formschlüssig verbunden, bis eine weitere Bewegung in Pfeilrichtung B von den Halteklauen 28, 28',... verhindert wird; die Maske wird danach vom Stößel 18 allein weiterbewegt, bis sie fest auf dem gegenüberliegenden Stößel 14 aufsitzt (wie dies die Zeichnung Pos. 2 zeigt). Das Substrat 20 kann nun von der Transportkelle ohne die Maske 15 nach einer Rückbewegung der Druckhülse 12 in die (nicht näher dargestellte) Ein-/Ausschleusposition verschwenkt werden.

Zum Zwecke des Austauschs einer bereits mehrfach beschichteten Maske 15 gegen eine noch unbenutzte bzw. unbeschichtete Maske 15 fährt der Stößel 14 der fest an einem in einer Schiene 35 geführten Gleitschuh 36 angeordnet ist soweit nach rechts (in Pfeilrichtung B), bis die Maske 15 etwa in der mit 15' bezeichneten und strichliert angedeuteten Position, nämlich genau gegenüber der Öffnung 37 in der Gehäusewand 2 steht (Pos. 3). Diese Öffnung 37 ist von einer Klappe 38 verschließbar und gestattet den Transport der Maske 15' in die Kammer 39 die ihrerseits über die Klappe 40 gegenüber dem die Vorrichtung umgebenden Raum abtrennbar ist. In der Kammer 39 bzw. in deren Kammerwand ist ein Schieber 41 in Pfeilrichtung C-D verschiebbar gelagert, dessen der Kammer 42 zugewandtes Kopfteil 43 gabelförmig ausgebildet ist. Es sei noch erwähnt, daß der Gleitschuh 36, der in der Schiene 35 gehalten und geführt ist mit Hilfe eines über Rollen 44,45 geführten Seilzugs bewegt wird, wozu die Rollen von nicht näher dargestellten Motoren angetrieben werden. Das gabelförmig ausgebildete Kopfteil 43 fährt bei geöffneter Klappe 38 soweit in Pfeilrichtung D auf die Maske 15' zu, bis die beiden Gabelzinken den krempenförmigen Teil 47 der Maske 15', die sich in der strichliert gezeichneten Position befindet (Pos. 3), umklammert. Wird nun der Gleitschuh 36 zusammen mit dem Stößel 14 nun um ein geringes Maß weiter nach rechts (Pfeilrichtung B) bewegt, dann wird die Maske 15' ausschließlich vom Kopfteil 43 gehalten und kann nun vom Schieber 41 in Pfeilrichtung C soweit in die Kammer 39 hineinbewegt werden, bis die Maske die strichliert gezeigte Position 15'' erreicht hat (Pos. 4). Jetzt kann die Klappe 38 in ihre Schließposition geschwenkt werden (wie in der Zeichnung dargestellt) und die Klappe 40 kann die Kammer 39 nach außen zu öffnen. Der Stößel 48 kann jetzt von außen her durch die Öffnung 49 hindurch in die Kammer 39 hineinbewegt werden bis sein einen Magneten aufweisendes Ende in die Sacklochbohrung der Maske 15'' eingetaucht ist. Mit Hilfe des Stößels 48 kann die Maske 15'' anschließend durch die Öffnung 49 hindurch nach außen transportiert werden und dort gegen eine andere (neuwertige) Maske ausgetauscht werden.

### Auflistung der Einzelteile

- 1: druckdichtes Gehäuse
- 2: druckdichtes Gehäuse
- 3: Kammer
- 4: Kammer
- 5: Öffnung
- 6: Transportkelle
- 7: Transportkelle
- 8: Nabe
- 9: Nabe
- 10: Antriebswelle
- 11: Antriebswelle
- 12: Druckhülse
- 13: Stößel
- 14: Stößel
- 15: Maske
- 16: Aufnahmebohrung
- 17: Ringmagnet
- 18: Stößel
- 19: Motor-Einheit
- 20: Substrat
- 21, 21': Federarm
- 22, 22': Federarm
- 23: Seitenwand der Kammer 3
- 24: Kopfteil
- 25: Öffnung
- 26: Bohrung, Durchgangsbohrung
- 27, 27': Halteklaue
- 28, 28': Haltenoppen, Nase
- 29: Substrataufnahme
- 30: Substrataufnahme
- 31: Bohrung
- 32: Sacklochbohrung
- 33: Magnet
- 35: Schiene
- 36: Gleitschuh
- 37: Öffnung, Durchlaß
- 38: Klappe
- 39: Kammer
- 40: Klappe
- 41: Schieber
- 42: Kammer
- 43: gabelförmiges Kopfteil
- 44: Rolle
- 45: Rolle
- 46: Seilzug
- 47: Krempe
- 48: Stößel
- 49: Öffnung, Durchlaß

## Patentansprüche

1. Vorrichtung zum Ein- und/oder Ausschleusen einer Maske für ein vorzugweise kreisringscheibenförmiges flaches Substrat (20) in die oder aus der Kammer (3,4,) einer Vakuum-Beschichtungsanlage, mit in einer ersten Ausschleuskammer (42) verschiebbar gelagerten bis in die Ebene des Substrats (20) bewegbarer Stößel (14) zur Halterung und zum Transport der mit einer Aufnahmebohrung (32) versehenen Maske (15, 15'...), wobei der Stößel (14) quer zur Ebene des Substrats (20) angeordnet ist und mit einem quer zur Längsrichtung des Stößels (14) bewegbaren Schieber (41) zusammenwirkt, dessen Kopfteil (43) gabelförmig ausgeformt ist und auf den krempenförmigen Rand (47) der Maske (15,15'...) aufschiebbar ist und diesen umklammert, wozu der Schieber (41) von seiner Ausgangsposition in einer zweiten Ausschleuskammer (39) in einer Vorschubbewegung bis an den Bewegungspfad des Stößels (14) heranführbar und dort auf den krempenförmigen Rand aufpreßbar ist und anschließend vom Schieber (41) in einer Rückhubbewegung in die zweite Ausschleuskammer (39) transportierbar ist aus der die Maske anschließend und nach dem Schließen einer die beiden Kammern (39 und 42) voneinander abtrennenden Klappe (38) mittels eines weiteren Stößels (48) heraustransportierbar ist.

2. Vorrichtung nach Anspruch 1, gekennzeichnet durch eine Transportkammer (3) mit einer in dieser angeordneten Substrataufnahme (29) die um eine quer zur Ebene der Substrataufnahme angeordnete Achse (a) schwenkbar ist und die dem Transport der Substrate (20) von und nach den Behandlungsstationen dient und mit einer quer zur Transportkammer (3) angeordneten ersten Ausschleuskammer (42), die über einen Durchlaß im Bereich des Substrat-Tranportweges mit der Tranportkammer (3) verbunden ist und einer über eine erste Schleuse (37,38) mit der zweiten Ausschleuskammer (39), die ihrerseits über eine zweite Schleuse (40,49) mit dem die Vorrichtung umgebenden Raum verbindbar ist.

3. Vorrichtung nach den Ansprüchen 1 und 2, gekennzeichnet durch einen in der ersten Ausschleuskammer (42) entlang einer Schiene (35) bewegbaren Gleitschuh (36) und einen mit dem Gleitschuh verbundenen Maskenhalter, einem Stößel (14) dessen vorderes Ende einerseits bis in die Ebene der Substrathalter (29) und darüberhinaus (Pos. 1) bewegbar ist und der zusammen mit dem Gleitschuh andererseits bis in eine Position (Pos. 3) in der Ebene der ersten Schleuse (37,38) verfahrbar ist.

4. Vorrichtung nach den vorhergehenden Ansprüchen, gekennzeichnet durch einen in der zweiten Ausschleuskammer (39) gelagerten Schieber (41) der in einer Ebene quer zur Längsachse des Stößels (14) verschiebbar ist und dessen Kopfteil (43) gabelförmig ausgebildet ist und bis in den Bereich des Gleitschuhpfads verfahrbar ist und mit seinen Gabelzinken die Maske (15) umgreift und diese vom Gleitschuhpfad aus (Pos. 3) bis in eine Position (Pos. 4) querab der zweiten Schleuse (40,49) oder in umgekehrter Richtung bewegt.

5. Vorrichtung nach einem oder mehreren der vorhergegangen Ansprüche, gekennzeichnet durch einen am Gehäuse (1) gelagerten Stößel (48) der parallel zum Gleitschuhpfad bewegbar ist und dessen Kopfende von einer Position (Pos. 5) außerhalb der zweiten Ausschleuskammer (39) bis in die Bewegungsebene des Schiebers (41) verschiebbar ist und dessen Kopfende der Aufnahme und Halterung der Maske (15) dient und hierzu beispielsweise mit einem Magneten versehen ist.

## Claims

1. Apparatus for transporting a mask for a preferably circular disc-shaped flat substrate into and/or out of the chamber (3, 4) of a vacuum coating plant, having a ram (14), which is displaceably mounted in a first outward transfer chamber (42) and is movable as far as into the plane of the substrate (20), for supporting and transporting the mask (15, 15', ...), which is provided with a receiving bore (32), wherein the ram (14) is disposed transverse to the plane of the substrate (20) and cooperates with a slide (41) moving transverse to the longitudinal direction of the ram (14), the head portion (43) of the slide (41) being fork-shaped and capable of being pushed over the rim-shaped edge (47) of the mask (15, 15', ...) so as to clip over the mask, to which end the slide (41) is capable of being brought from its starting position in a second outward transfer chamber (39) in a forward feed motion up to the path of motion of the ram (14) and of being pressed over the rim-shaped edge, and is then transportable by the slide (41) in a reverse stroke motion into the second outward transfer chamber (39), from which the mask, after closing of a flap (38) separating the two chambers (39 and 42) from one another, can then be transported out by means of a further ram (48).

2. Apparatus according to claim 1, characterised by a transport chamber (3) having a substrate seat (29) disposed therein, which is pivotable about an axis (a) oriented transverse to the plane of the substrate seat and transports the substrates (20) from and to the treatment bays, and having a first outward transfer chamber (42), which is disposed transverse to the transport chamber (3) and is connected on the one hand via a hole in the region of the substrate transport path to the transport chamber (3) and on the other hand via a first trap (37,38) to the second outward transfer chamber (39), which is in turn connectable via a second trap (40, 49) to the space surrounding the apparatus.

3. Apparatus according to claims 1 and 2, characterised by a sliding block (36) movable along a rail (35) in the first outward transfer chamber (42) and by a mask holder connected to the sliding block, to a ram (14) whose front end is movable into the plane of the substrate holder (29) and beyond (Pos. 1), and which is movable together with the sliding block into a position (Pos. 3) in the plane of the first trap (37, 38).

4. Apparatus according to the preceding claims, characterised by a slide (41) which is mounted in the second outward transfer chamber (39) and is displaceable in a plane transverse to the longitudinal axis of the ram (14), and whose head portion (43) is fork-shaped and is movable into the region of the sliding block path and engages round the mask (15) with its fork prongs and moves the mask from the sliding block path (Pos. 3) into a position (Pos. 4) transverse to the second trap (40, 49), or in the reverse direction.

5. Apparatus according to one or more of the preceding claims, characterised by a ram (48), which is mounted on the housing (1) and is movable parallel to the sliding block path and whose head end is movable from a position (Pos. 5) outside the second outward transfer chamber (39) into the plane of motion of the slide (41) and whose head end receives and holds the mask (15) and is provided to this end with a magnet for example.

## Revendications

1. Dispositif pour faire entrer et/ou sortir un masque pour un substrat plat (20) de préférence en forme de disque circulaire dans ou hors de la chambre (3, 4) d'une installation de revêtement sous vide, comportant un poinçon (14) monté de façon déplaçable dans une première chambre de sortie (42) et mobile jusque dans le plan du substrat (20) pour la retenue et le transport du masque (15, 15', ...) qui est pourvu d'un perçage de réception (32), le poinçon (14) étant agencé transversalement par rapport au plan du substrat (20) et coopérant avec un poussoir (41) mobile transversalement par rapport à la direction longitudinale du poinçon (14), la partie de tête (43) de ce poussoir étant réalisée en forme de fourche et susceptible d'être enfichée sur la bordure (47) en forme de rebord du masque (15, 15') et enserrant celle-ci, ce pourquoi le poussoir (41) peut être amené depuis sa position de départ dans une seconde chambre de sortie (39) suivant un mouvement d'avance jusqu'au parcours de déplacement du poinçon (14), et y être pressé sur la bordure en forme de rebord, et ensuite être transporté par le poussoir (41) suivant un mouvement de retour dans la seconde chambre de sortie (39), hors de laquelle le masque peut être ensuite transporté après la fermeture d'un clapet (38) qui sépare les deux chambres (39 et 42) l'une de l'autre, au moyen d'un autre poinçon (48).

2. Dispositif selon la revendication 1, caractérisé par une chambre de transport (3) comportant un récepteur de substrats (29) agencé dans celle-ci, qui est susceptible d'être basculé autour d'un axe (a) agencé transversalement par rapport au plan du récepteur de substrats, et qui sert au transport des substrats (20) depuis et vers les stations de traitement, et comportant une première chambre de sortie (42) agencée transversalement par rapport à la chambre de transport (3), cette première chambre de sortie étant reliée d'une part via un passage dans la région du trajet de transport des substrats à la chambre de transport (3), et d'autre part via un premier passage (37, 38) à la seconde chambre de sortie (39), qui peut être reliée à son tour via un second passage (40, 49) à l'espace qui entoure le dispositif.

3. Dispositif selon les revendications 1 et 2, caractérisé par un patin coulissant (36) mobile dans la première chambre de sortie (42) le long d'un rail (35), et par un porte-masque relié au patin coulissant, par exemple un poinçon (14) dont l'extrémité avant peut être déplacée d'une part jusque dans le plan des porte-substrats (29) et au-delà de celui-ci (pos. 1), et ce poinçon pouvant être déplacé conjointement avec le patin coulissant d'autre part jusque dans une position (pos. 3) dans le plan du premier passage (37, 38).

4. Dispositif selon les revendications précédentes, caractérisé par un poussoir (41) monté dans la seconde chambre de sortie (39), qui est mobile dans un plan transversalement par rapport à l'axe longitudinal du poinçon (14), et dont la partie de tête (43) est réalisée en forme de fourche et mobile jusque dans la région du parcours du patin coulissant et enserre par ses dents le masque (15) et déplace celui-ci depuis le parcours du patin coulissant (pos. 3) jusque dans une position (pos. 4) en travers du second passage (40, 49), ou en direction inverse.

5. Dispositif selon l'une ou plusieurs des revendications précédentes, caractérisé par un poinçon (48) monté sur le boîtier (1), qui est mobile parallèlement au parcours du patin coulissant, et dont l'extrémité de tête est mobile depuis une position (pos. 5) à l'extérieur de la seconde chambre de sortie (39) jusque dans le plan de mouvement du poussoir (41), et dont l'extrémité de tête sert à la réception et à la retenue du masque (15) et est pourvue à cet effet par exemple d'un aimant.
